(19) Europäisches Patentamt
European Patent Office
Office européen des brevets

(11) **EP 4 131 763 B1**

(12) **EUROPEAN PATENT SPECIFICATION**

(45) Date of publication and mention
of the grant of the patent:
**17.09.2025  Bulletin 2025/38**

(21) Application number: **20927721.9**

(22) Date of filing: **03.12.2020**

(51) International Patent Classification (IPC):
*H01L 23/473* (2006.01)     *H01L 25/07* (2006.01)
*H01L 25/16* (2023.01)     *H01L 25/18* (2023.01)
*H02M 7/00* (2006.01)     *H01L 23/367* (2006.01)
*H01L 23/433* (2006.01)

(52) Cooperative Patent Classification (CPC):
**H02M 7/003; H01L 23/473; H01L 25/072;**
**H01L 25/16; H01L 25/18;** H01L 23/3672;
H01L 23/4334; H01L 2224/33181

(86) International application number:
**PCT/JP2020/044950**

(87) International publication number:
**WO 2021/192424 (30.09.2021 Gazette 2021/39)**

(54) **POWER CONVERSION DEVICE**

STROMUMWANDLUNGSVORRICHTUNG

DISPOSITIF DE CONVERSION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.03.2020  JP 2020051009**

(43) Date of publication of application:
**08.02.2023  Bulletin 2023/06**

(73) Proprietor: **Hitachi, Ltd.**
**Tokyo 100-8280 (JP)**

(72) Inventor: **ASAI, Kyota**
**Tokyo 100-8280 (JP)**

(74) Representative: **MERH-IP Matias Erny Reichl
Hoffmann
Patentanwälte PartG mbB
Paul-Heyse-Straße 29
80336 München (DE)**

(56) References cited:
**WO-A1-2013/151606      WO-A1-2014/136354
JP-A- 2006 310 363      JP-A- 2019 021 864
US-A1- 2008 224 303      US-A1- 2012 228 757
US-A1- 2014 198 449**

**Description**

Technical Field

The present invention relates to an electric power conversion device.

Background Art

Although there is a tendency that the electric energy that the electric power conversion device converts is increased in recent years, miniaturization and weight saving are requested for the entire of automobiles and increasing in size and increasing in weight of the electric power conversion device are suppressed. In addition, an in-vehicle electric power conversion device is requested to be used in an environment that a change in temperature is large in comparison with an industrial-use one and so forth and an electric power conversion device which can maintain high reliability while being placed in a high-temperature environment is requested.

A switching operation that semiconductor modules which configure upper and lower arms of an inverter circuit repeat a cutoff state and a conduction state is necessary for performing electric power conversion. At the time of the switching operation, a transient current which passes through the upper and lower arms flows and this causes a surge voltage by being affected by a parasitic inductance of wiring. Thereby, a loss of the semiconductor module is increased and a chip temperature of the semiconductor module rises. Accordingly, in order to suppress temperature rising, to reduce the inductance which causes the temperature rising and to improve cooling performance become important issues.

In Patent Literature 1, there is disclosed an electric conversion device which is equipped with a semiconductor module which builds therein a series circuit for an upper arm circuit and a lower arm circuit which configure an inverter circuit, and a smoothing capacitor for smoothing a DC voltage which is to be supplied to the semiconductor module, wherein a plural number of the semiconductor modules is installed and each semiconductor module is equipped with a first power semiconductor element which configures the upper arm circuit, a second power semiconductor element which configure the lower arm circuit, a first conductor plate which is arranged on one side of the first power semiconductor element and is connected with one electrode of the first power semiconductor element concerned via solder, a second conductor plate which is arranged on the other side of the first power semiconductor element and is connected with the other electrode of the first power semiconductor element concerned via solder, a third semiconductor plate which is arranged on one side of the second power semiconductor element and is connected with one electrode of the second power semiconductor element concerned via solder, a fourth conductor plate which is arranged on the other side of the second power semiconductor element and is connected with the other electrode of the second power semiconductor element concerned via solder, a first metallic heat radiation plate which is arranged at a position where it is opposite to the first conductor plate and the third conductor plate via a first insulation member, a second metallic heat radiation plate which is arranged at a position where it is opposite to the second conductor plate and the fourth conductor plate via a second insulation member, and a cathode terminal and an anode terminal which supply an electric current to the series circuit, wherein the first power semiconductor element and the second power semiconductor element and the first conductor plate and the second conductor plate and the third conductor plate and the fourth conductor plate are arranged so as to form a loop-shaped recovery electric current path when the recovery electric current flows in order of the first conductor plate concerned, the first power semiconductor element concerned, the second conductor plate concerned, the third conductor plate concerned, the second power semiconductor element concerned, the fourth conductor plate concerned, and an eddy current is induced on the first heat radiation plate and the second heat radiation plate by the loop-shaped recovery current. Patent Literature 2 shows a cooling type switching element module that includes an outer conductor pipe, an inner conductor pipe that transmits electric power in conjunction with the outer conductor pipe, and first and second switching elements.

Patent Literature 3 shows a cooling structure of a semiconductor device that includes an output electrode, a semiconductor element and a semiconductor element disposed to face each other with the output electrode interposed therebetween, a radiator disposed for the semiconductor element on a side opposite to the output electrode, and a radiator disposed for the semiconductor element on the side opposite to the output electrode.

Patent Literature 4 shows some embodiments, in that a semiconductor cooling apparatus includes a heat exchanger configured to thermally couple to a semiconductor element to transfer heat to coolant flowing through the heat exchanger. Patent Literature 5 shows a power semiconductor module. Insulating substrates with electrode metal layers disposed thereon are joined to both the surfaces of a power semiconductor chip by using, for example, soldering.

Citation List

Patent Literature 1: Japanese Patent Application Laid-Open No. 2015-43690
Patent Literature 2: US 2014/198449 A1
Patent Literature 3: US 2012/228757 A1
Patent Literature 4: WO 2013/151606 A1
Patent Literature 5: US 2008/224303 A1

Summary of Invention

Technical Problem

In the invention which is described in the Patent Literature 1, there is room for improvement in simultaneous achievement of cooling and inductance reduction.

The above cited object is achieved by the subject-matter of the appended set of claims. Embodiment 2 is not encompassed by the wording of the claims but it is considered as useful for understanding the invention. In particular, the claimed subject-matter includes an electric power conversion device which is equipped with a power module which converts DC electric power to AC electric power, a substrate that the power module is arranged and a DC path which transmits the DC electric power to the power module is included and which has a first surface and a second surface which confronts the first surface and has a plurality of main flow path holes which is pierced therethrough from the first surface to the second surface, and a flow path forming body which covers at least parts of the first surface and the second surface of the substrate so as to cover the plurality of main flow path holes and forms a flow path of a refrigerant which cools the power module, in which the plurality of main flow path holes is arranged at a position where they cross the DC path, and the refrigerant migrates from the first surface to the second surface, passing through the main flow path holes.

Advantageous Effects of Invention

According to the present invention, the cooling and the inductance reduction can be simultaneously achieved.

Brief Description of Drawings

Fig, 1 is a plan view of an electric power conversion device in the first embodiment.

Fig. 2 is a plan view of the electric power conversion device that a flow path forming body is erased from Fig. 1.

Fig. 3 is a plan view of the electric power conversion device that a mold resin is erased from Fig. 2.

Fig. 4 is a sectional diagram of the electric power conversion device showing the IV-IV section in Fig. 1 to Fig. 3.

Fig. 5 is an electric circuit diagram of the electric power conversion device in the first embodiment.

Fig. 6 is a plan view of a power module.

Fig. 7 is a perspective view of the power module.

Fig. 8 is a front view of the power module.

Fig. 9 is a plan view of an electric power conversion device pertaining to the second embodiment.

Fig. 10 is a sectional diagram showing the X-X section in Fig. 9.

Fig. 11 is a plan view of an electric power conversion device in the third embodiment.

Fig. 12 is an electric circuit diagram of the electric power conversion device in the third embodiment.

Description of Embodiments

First Embodiment

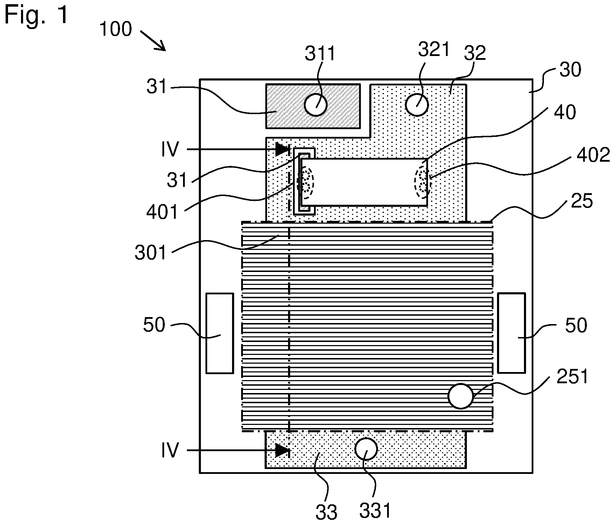

In the following, the first embodiment of the electric power conversion device will be described with reference to Fig. 1 to Fig. 8.

In the following, the embodiments of the present invention will be described with reference to the drawings. Incidentally, the same signs are assigned to the same elements in respective drawings and duplicated explanation thereof will be omitted.

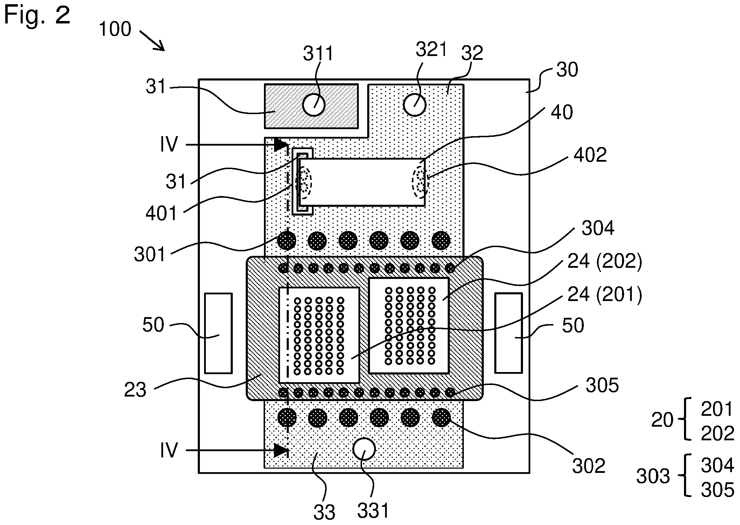

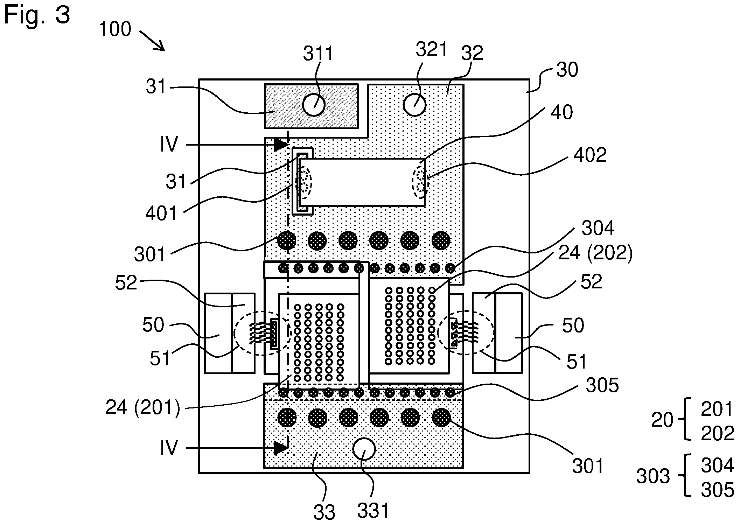

Fig. 1 is a plan view of an electric power conversion device 100, Fig. 2 is a diagram that a flow path forming body 25 is erased from Fig. 1, and Fig. 3 is a diagram that a mold resin 23 is erased from Fig. 2. The electric power conversion device 100 is an electric power conversion device which converts DC electric power which is obtained from a battery and so forth into AC electric power which is to be supplied to an electric motor and so forth and configures an upper arm circuit and a lower arm circuit for one phase. However, in Fig. 1, a power module is hidden behind the mold resin 23 and therefore is not illustrated.

As shown in Fig. 1, the electric power conversion device 100 is equipped with a cathode conductor layer 31, an anode conductor layer 32, an AC output terminal conductor 33, a capacitor 40, a control circuit 50 which generates a control signal, and a flow path forming body 25. The flow path forming body 25 is equipped with a refrigerant inlet port 251 which extends to the illustrated front side. The cathode conductor layer 31, the anode conductor layer 32, and the AC output terminal conductor 33 are included in any of layers of a substrate 30 which is a tabular multi-layered substrate. Incidentally, in Fig. 1 to Fig. 3, hatching is applied in order to clearly indicate correspondence with a sectional diagram which will be shown later.

As aforementioned, Fig. 2 is the drawing that the flow path forming body 25 is erased from Fig. 1 and configurations which were present on the inner side of the flow path forming body 25 in Fig. 1 are clearly shown. As shown in Fig. 2, the substrate 30 is further equipped with a first power module 201, and a second power module 202. The first power module 201 and the second power module 202 are equipped with heat radiation fins 24 respectively and they are superposed on the first power module 201 and the second power module 202 in a deep direction at view points in Fig. 2 and Fig. 3.

The first power module 201 and the second power module 202 are sealed with the mold resin 23 and one surface of the heat radiation fin 24 is exposed to the outside of the mold resin 23. Since the periphery of the mold resin 23 is surrounded by the flow path forming body 25, the surfaces of the heat radiation fins 24 are cooled with a refrigerant. Incidentally, the first power module 201 and the second power module 202 are electrically insulated from the refrigerant with the mold resin 23. In the following, the first power module 201 and the second power module 202 will be collectively called a power module 20.

As shown in Fig. 2, the substrate 30 has four kinds of holes. The four kinds are a main flow path hole 301, a sub-flow path hole 302, a DC side resin-filled hole 304, and an AC side resin-filled hole 305. In the following, an illustrated front-side surface of the substrate 30 will be called a first surface S1 and an illustrated back-side surface will be called a second surface S2. In addition, in the following, the DC side resin-filled hole 304 and the AC side resin-filled hole 305 will be called a resin-filled hole 303 collectively. Any of the main flow path hole 301, the sub-flow path hole 302, and the resin-filled hole 303 is a hole which is pierced therethrough from the first surface S1 to the second surface S2 of the substrate 30. The shapes of the main flow path hole 301 and the sub-flow path hole 302 are almost the same as each other. The diameter of the resin-filled hole 303 is smaller than the diameters of the main flow path hole 301 and the sub-flow path hole 302.

The main flow path hole 301 and the sub-flow path hole 302 have roles as flow paths which are adapted for migration of the refrigerant from the first surface S1 to the second surface S2. However, the main flow path hole 301 also has other roles which will be described later. Any of the main flow path hole 301, the sub-flow path hole 302, and the resin-filled hole 303 has a conductor in its inner wall and therefore also has a function of connecting together respective layers of the substrate 30 which is the multi-layered substrate. Since the substrate 30 is equipped with the plurality of layers and various electronic devices are connected with the substrate 30, a bus bar which has a complicated shape becomes unnecessary and productivity is improved.

The first power module 2011 is connected to the cathode conductor layer 31 which has a cathode power source terminal 311, and the AC output terminal conductor 33 which has an AC output terminal 331. The second power module 202 is connected to the anode conductor layer 32 which has an anode power source terminal 321 and the AC output terminal conductor 33. Thereby, electric energy is supplied from the battery to the first power module 201 and the second power module 202. In addition, the first power module 201 and the second power module 202 output AC electric power from the AC output terminal 331 which is provided on the AC output terminal conductor 33.

The substrate 30 is configured by a plurality of conductor layers which is configured by a copper material and so forth, and by an insulation member such as a glass epoxy resin and so forth. In the present embodiment, the substrate 30 has four conductor layers. Although a lower surface and the second inner layer of the substrate 30 serve as main electric current paths for the anode conductor layer 31 that the anode power source terminal 311 is installed, it is connected to the first power module 201 via the resin-filled holes 303 in the vicinity of a part of connection with the first power module 201 which is connected to an upper surface of the substrate 30. On the other hand, the upper surface and the third inner layer of the substrate 30 serve as main electric current paths for the anode conductor layer 32 that the anode power source terminal 321 is installed. Electric currents which flow in respective conductors mutually confront owing to a laminated structure of the cathode conductor layer 31 and the anode conductor layer 32 in this way, and an inductance can be reduced owing to a magnetic flux cancellation effect.

The AC output terminal conductor 33 has the AC output terminal 331 which is formed on each layer through the resin-filled holes 303 and outputs the AC electric power to an electric motor. Thereby, the sectional area of the conductor is increased and the inductance can be reduced.

The capacitor 40 is configured by a film capacitor and so forth. The capacitor 40 is physically and electrically loaded between the first power module 201 and the second power module 202, and the cathode power source terminal 311 and the anode power source terminal 321. The capacitor 40 has a cathode terminal 401 and an anode terminal 402, and the cathode terminal 401 and the anode terminal 402 are arranged in parallel relative to the first power module 201 and the second power module 202. Thereby, a path of an electric current which flows from the capacitor 40 into the first power module 201 and a path of an electric current which flows from the second power module 202 out to the capacitor 40 can be made uniform and the inductance can be reduced.

Control circuits 50 are connected to the first power module 201 and the second power module 202 via control signal wiring 51 such as wire bonding and so forth and are arranged adjacently thereto respectively. Thereby, a loss increase is prevented by reducing the inductance of the control signal wiring 51 and preventing a reduction in element driving performance. The control signal wiring 51 is connected to the control circuits 50 via intra-flow path substrate wiring 52 which is installed on the substrate 30.

The aforementioned main flow path holes 301 are physically installed between the first power module 201 and the second power module 202, and the capacitor 40. The aforementioned sub-flow path holes 302 are physically installed between the first power module 201 and the second power module 202, and the AC output terminal 331.

The main flow path holes 301 bring all the conductor layers which are installed in the substrate 50 into communication with one another and the plurally of them is installed in parallel relative to the first power module 201 and the second power module 202. The substrate 30 is, all the conductors of four layers are configured by conductors of either the cathode conductor layer 31 or the anode conductor layer 32 and the mutually adjacent main flow path holes 301 alternately form the conductor layer respectively. Thereby, paths of the electric currents which flow through the cathode conductor layer 31 and the anode conductor layer 32 cover a wide range, the magnetic flux cancellation effect is strengthened and thereby the inductance can be reduced.

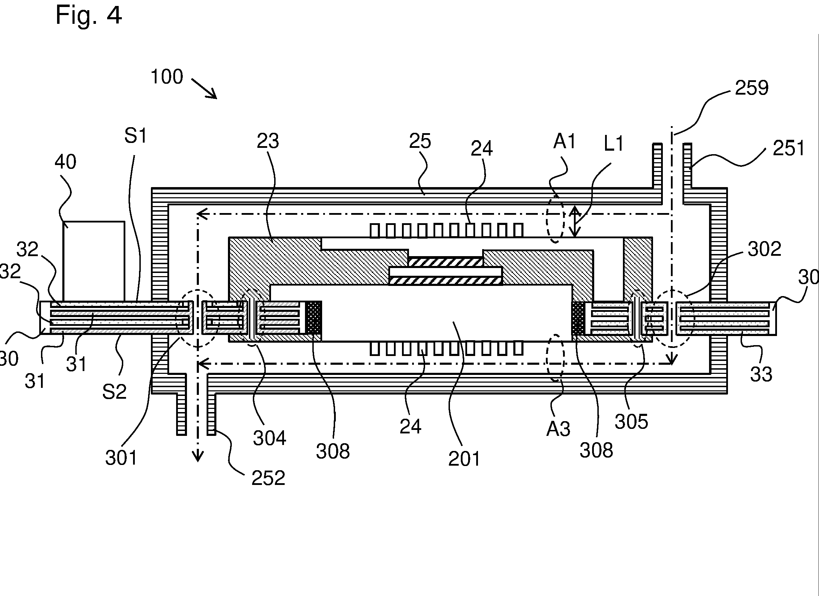

Fig. 4 is a sectional diagram showing the IV-IV section which is shown in Fig. 1 to Fig. 3. An illustrated upper part is the first surface S1 of the substrate 30 and an illustrated lower part is the second surface S2 of the substrate 3. The first power module 201 which is sealed to the mold resin 23 is shown at the center in Fig. 4 and the flow path forming body 25 surrounds the periphery of the mold resin 23. Accordingly, a refrigerant flow path is formed between the mold resin 23 and the flow path forming body 25. In addition, in Fig. 4, for explanation's shake, the flow path of the refrigerant is indicated by a one-dot chain line which is denoted by a sign 259. The refrigerant flows from the refrigerant inlet port 251 which is shown on the upper right in Fig. 4 to a refrigerant outlet port 252 which is shown on the lower left. The refrigerant divergently flows clockwise and counterclockwise.

Here, it is defined that a sectional area of a counterclockwise upper flow path is A1 and a sectional area of a clockwise upper flow path is A3. In a case where the flow path is rectangular, for example, the sectional area A1 is obtained as a product of an illustrated height-direction size L1 and a depth-direction size. It is desirable that this sectional area A1 be equal to the sum of the sectional areas of the main flow path holes 301. For example, in a case where an inner diameter of the main flow path hole 301 is set as "r1" and the total number of the main flow path holes 301 is set as "N1", it is desirable that the following numerical formula 1 be established. Incidentally, in the examples which are shown in Fig. 2 to Fig. 3, N1 is "6". If this equality is established, it will become possible to prevent inhibition of a flow of the refrigerant which is caused by the small areas of the main flow path holes 301 in the counterclockwise flow path.

$$A1 = r1 \cdot rt \cdot \pi \times N1 \ldots \text{(Numerical Formula 1)}$$

In addition, in a case where an inner diameter of the sub-flow path hole 302 is set as "r2" and the total number of the sub-flow holes 302 is set as "N2", it is desirable that the following numerical formula 2 be established. Incidentally, N2 is "6" in the examples which are shown in Fig. 2 to Fig. 3. If this equality is established, it will become possible to prevent the inhibition of the flow of the refrigerant due to the small areas of the sub-flow path holes 302 in the clockwise flow path.

$$A3 = r2 \cdot r2 \cdot \pi \times N2 \ldots \text{(Numerical Formula 2)}$$

The first power module 201 and the second power module 202 are built into a power module built-in hole 308 which is present in the substrate 30 and are sealed with the mold resin 23. The first power module 201 and the second power module 202 are in contact with the heat radiation fins 24 via solder on upper and lower surfaces as shown in FIG. 4. Since the flow path forming body 25 covers an outer periphery of the mold resin w23 that the surfaces of the heat radiation fins 24 are exposed, the surfaces of the heat radiation fins 24 come into contact with the refrigerant. Accordingly, a heat radiation path with no interposition of an insulation member is formed, ranging from semiconductor elements of the first power module 201 and the second power module 202 to the heat radiation fins 24, and the heat radiation fins 24 are directly cooled with the refrigerant such as oil and so forth. Thereby, it becomes possible to suppress an increase in thermal resistance and to promote an increase in output from the electric power conversion device. In addition, a flow path of the refrigerant can be shortened by installing the main flow path holes 301 and the sub-flow path holes 302 adjacent to the mold resin 23 and cooling efficiency is improved owing to a reduction in pressure loss.

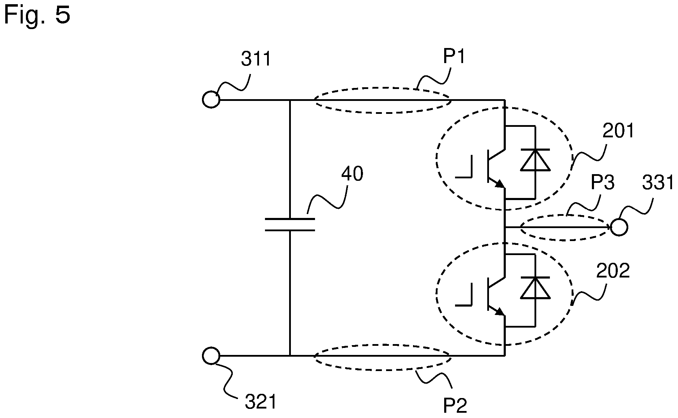

Fig. 5 is an electric circuit diagram of the electric power conversion device 100. As has been explained so far, the capacitor 40 is connected in parallel with the first power module 201 and the second power module 202. A path between the capacitor 40 and the first power module 201 is called "P1" and a path between the capacitor 40 and the second power module 202 is called "P2". In addition, a path between the first power module 201 and the second power module 202, and the AC output terminal 331 is called "P3". Since DC flows through P1 and P2 and therefore they can be called "DC paths". Since AC flows through P3, it can be called an "AC path".

A positional relation between these paths and the aforementioned four kinds of holes is as follows. An array of the direct-flow path holes 301 and an array of the DC side resin-filled holes 304 are arranged at positions where they cross the DC paths P1 and P2. An array of the sub-flow path holes 302 and an array of the AC side resin-filled holes 305 are disposed at positions where they cross the AC path P3.

In the DC path P1 and the DC path P2, the inductance is reduced owing to presence of the main flow path holes 301 and the resin-filled holes 303 for reasons which will be described next. In a case where the main flow path holes 301 and the resin-filled holes 303 are not present in the substrate 30, the electric current path on the substrate 30 is limited to only a path that terminals are connected together with a straight line and the electric current concentrates to one path. However, in the present embodiment, since the main flow path holes 301 and the resin-filled holes 303 are present on the aforementioned straight-line path, the electric current takes a path which detours that hole. For example, since this electric current takes a path which makes a detour to the right side in a travelling direction and a path which makes a detour to the left side in the travelling direction, the path of the electric current is dispersed owing to presence of the main flow path holes 301 and the resin-filled holes 303. This is equivalent to that the electric current path is substantially widened, that is, the inductance is reduced.

Incidentally, although the smaller the diameter of the hole is, the higher the effect of path dispersion is, the resin-filled holes 303 are higher than the main flow path holes 301 in the effect of path dispersion from the following reason. That is, since the main flow path holes 301 become large in resistance when the refrigerant flows therethrough in a case where the diameters thereof are small, there is a limitation in the point of making the diameters thereof small. On the other hand, since it is sufficient for the resin-filled holes 303 that the resin can pass through them in a manufacturing process, the diameters thereof can be made small in comparison with those of the main flow path holes 301.

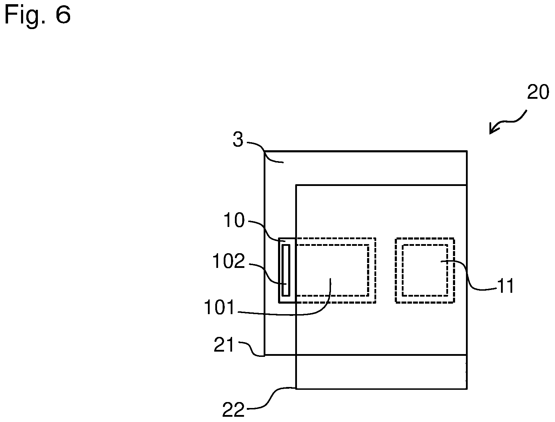

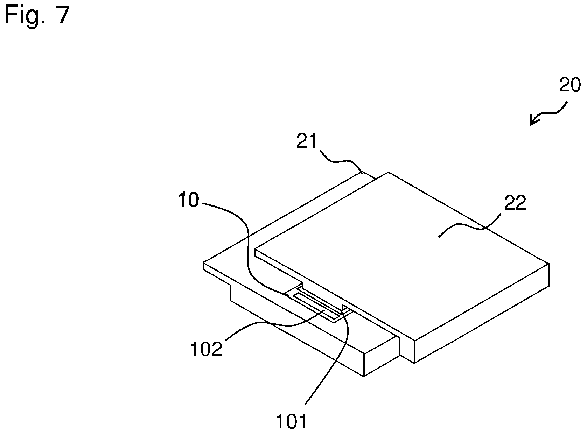

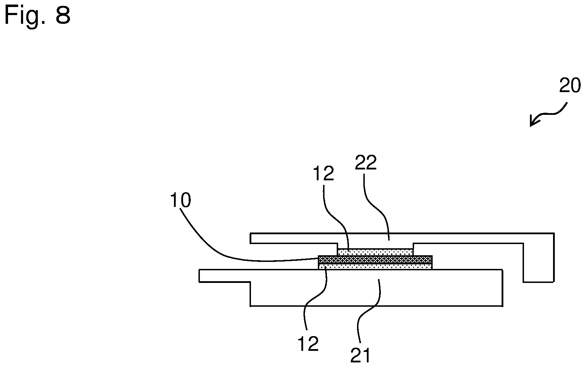

Fig. 6 to Fig. 8 are diagrams showing outlines of the power module 2. Fig. 6 is a plan view of the power module 20, Fig. 7 is a perspective view of the power module 20, and Fig. 8 is a front view of the power module 20. However, in Fig. 6, a configuration which is shaded is shown by a broken line for clearly showing the configuration.

The power module 20 configures an upper arm circuit or a lower arm circuit for one phase in the electric power conversion device which converts the DC electric power to the AC electric power. The power module 20 is equipped with an IGBT 10, a diode 11, a collector conductor plate 21, and an emitter conductor plate 22. The plate-shaped IGBT 10 has a main electrode 101 and a control electrode 102 which controls a main electric current which flows into the main electrode 101 concerned. The collector conductor plate 21 and the emitter conductor plate 22 are configured by a copper material. The IGBT 10 and the diode 11 are sandwiched by the collector conductor plate 21 and the emitter conductor plate 22 from both surfaces respectively. The IGBT 10 and the diode 11 are connected to the collector conductor plate 21 and the emitter conductor plate 22 via a metal joining material such as solder and so forth.

According to the above-described first embodiment, the next operational effects can be obtained.

(1) The electric power conversion device 100 is equipped with the power module 20 which converts the DC electric power to the AC electric power, the substrate 30 that the power module 20 is installed and the DC path which transmits the DC electric power to the power module 20 is included and which has the first surface S1 and the second surface S2 which confronts the first surface S1 and has the plurality of main flow path holes 301 which are pierced therethrough from the first surface S1 to the second surface S2, and the flow path forming body 25 which covers at least parts of the first surface S1 and the second surface S2 of the substrate so as to cover the plurality of main flow path holes 301 and forms the flow path of the refrigerant which cools the power module 20. The plurality of main flow path holes 301 is arranged at the position where they cross the DC paths P1 and P2. The refrigerant migrates from the first surface S1 to the second surface S2, passing through the main flow path holes 301. Accordingly, since the power module 20 can be cooled with the refrigerant and, in addition, the DC path is dispersed owing to presence of the main flow path holes 301 and thereby the range is widened, and the magnetic flux cancellation effect is strengthened, and thereby the inductance can be reduced. That is, the electric power conversion device 100 can simultaneously achieve the cooling and the inductance reduction.

(2) The power module 20 is cooled with the refrigerant which flows along the first surface S1, and with the refrigerant which flows along the second surface S2. Accordingly, the electric power conversion device 100 can cool the power module 20 from the both surfaces.

(3) The substrate 30 has the plurality of sub-flow path holes 302 which is pierced therethrough from the first surface S1 to the second surface S2, crossing the AC path P3 which transmits AC electric power to the power module 20. Accordingly, the refrigerant which cools the power module 20 can be distributed to two paths for cooling the upper surface and cooling the lower surface, and a loss in pressure can be reduced by shortening the flow path. In other words, in a case where they have the same pressure difference, the flow rate can be increased by dividing the path into two and thereby cooling ability can be strengthened.

(4) The substrate 30 is confi0gured by laminating the cathode conductor layer 31 that the electric current which flows into the power module 20 flows and the anode conductor layer 32 that the electric current which flows out of the power module flows. Accordingly, the inductance can be reduced by cancellation of the magnetic flux.

(5) The capacitor 40 is arranged on the DC flow paths P1 and P2 at a position where it is not covered with the flow path forming body 25. The capacitor 40 is electrically connected in parallel with the power module 20. Accordingly, the path of the electric current which flows from the capacitor 40 into the first power module 201 and the path of the electric current which flows from the second power module 202 out to the capacitor 40 can be made uniform and thereby the inductance can be reduced.

(6) The power module 20 includes the first power module 201 which configures the upper arm and the second power module 202 which configures the lower arm.

(7) The power module 20 is sealed with the mold resin 23. The flow path forming body 25 covers the outer periphery of the mold resin 23. The substrate 30 has the plurality of the DC side resin-filled holes 304 which is filled with the mold resin 23 and is pierced therethrough from the first surface S11 to the second surface S2. The DC side resin-filled holes 304 are arranged at a position where they cross the DC paths P1 and P2. Accordingly, also the DC side resin filled holes 304 have the effect of dispersing the DC path and hence the inductance can be reduced.

(8) The diameter of the resin-filled hole 33 is smaller than the diameter of the main flow path hole 301. Accordingly, the DC path can be more dispersed and hence the inductance can be more reduced.

(Modified Example)

The electric power conversion device 100 may be equipped with only one power module. The electric power conversion device 100 may not be equipped with at least one of the DC side resin-filled hole 304 and the AC side resin-filled hole 305. The power module 20 may be equipped with the heat radiation fin 24 only on one surface. That is, it may be also configured to cool the power module 20 only from one surface of the first surface S1 and the second surface S2 of the substrate 30. The shapes of the main flow path hole 301 and the sub-flow path hole 302 may be different from each other and, for example, the sizes of the diameters of the both may be different from each other.

Second Embodiment

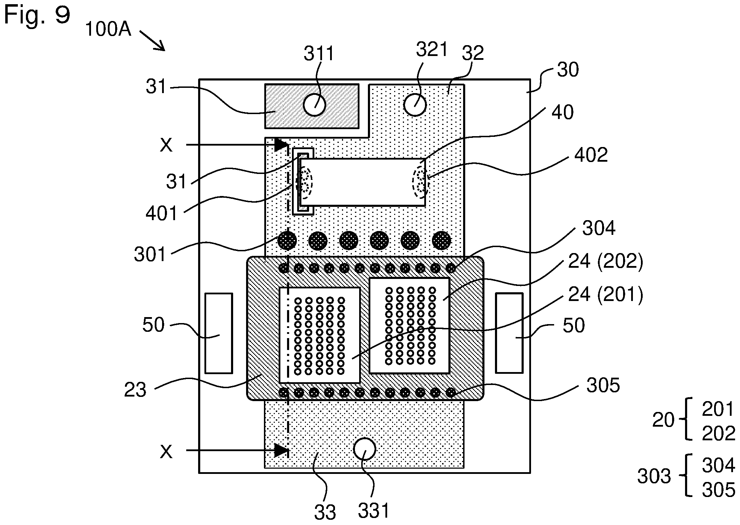

The second embodiment of the electric power conversion device will be described with reference to Fig. 9 to Fig. 10. In the following description, different points will be mainly described by assigning the sign which is the same as that to the configurational element which is the same as that in the first embodiment. In regards to the points which are not specifically described, they are the same as those in the first embodiment. In the present embodiment, mainly, in the point that it is not equipped with the sub-flow path holes, it is different from the first embodiment.

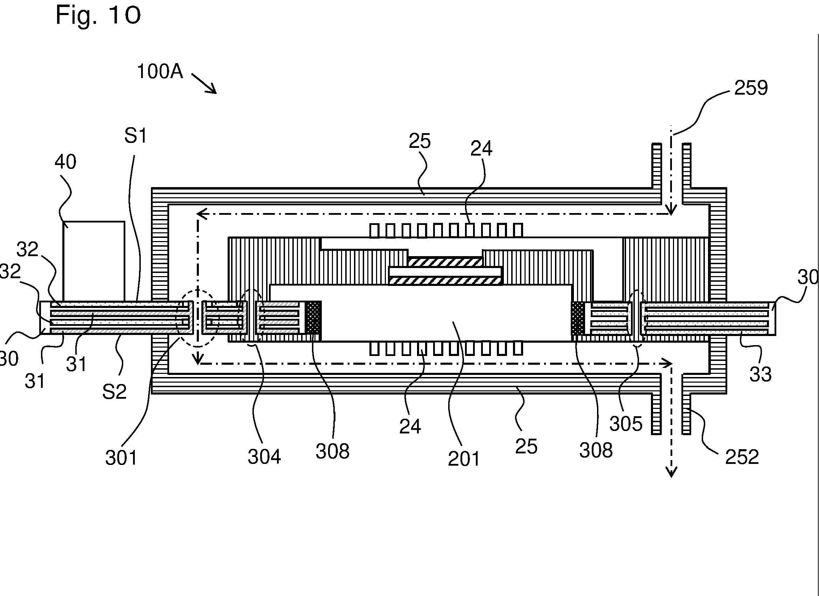

Fig. 9 is a plan view of an electric power conversion device 100A pertaining to the second embodiment. However, in Fig. 9, it is shown with the flow path forming body 25 being erased. That is, Fig. 9 corresponds to Fig. 2 of the first embodiment. The electric power conversion device 100A which is shown in Fig. 8 is different from the electric power conversion device 100 of the first embodiment in the point that it is not equipped with the sub-flow path holes 302 which is present in Fig. 2. In addition, although it is not illustrated at the view point of Fig. 9, because it is present behind the substrate 30, the position of the refrigerant outlet port 252 is different from that in the first embodiment. A difference in operation which is caused by the difference in configuration will be described with reference to Fig. 10.

Fig. 10 is a sectional diagram showing the X-X section in Fig. 9. Fig. 10 corresponds to Fig. 4 in the first embodiment. The refrigerant outlet port 252 which is present on the illustrated left lower part in Fig. 4 in the first embodiment moves to the illustrated right lower part in Fig. 10. As aforementioned, since the electric power conversion device 100A pertaining to the second embodiment is not equipped with the sub-flow path holes 302, only the counterclockwise flow path is present in Fig. 10. Although in the first embodiment, the heat radiation fins 24 on the illustrated lower part is cooled with the refrigerant which flows through the clockwise flow path, in the present embodiment, all the heat radiation fins 24 are cooled with the refrigerant which flows through the counterclockwise flow path.

According to the above described second embodiment, since formation of the sub-flow path holes 302 at machining of the substrate 30 is not necessary in comparison with the first embodiment, man-hour is reduced and the productivity is improved.

Third Embodiment

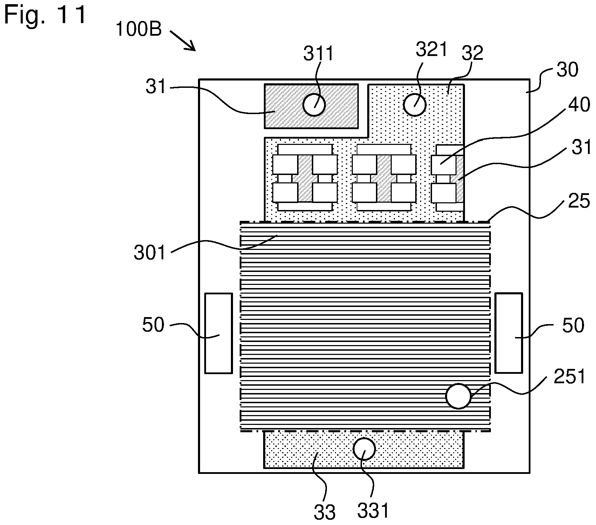

The third embodiment of the electric power conversion device will be described with reference to Fig. 11 to Fig. 12. In the following description, different points will be mainly described, by assigning the sign which is the same as that in the first embodiment to the configurational element which is the same as that in the first embodiment. In regards to points which are not described in particular, they are the same as those in the first embodiment. In the present embodiment, it is different from the first embodiment mainly in the point that it is equipped with the plurality of capacitors.

Fig. 11 is a plan view of an electronic power conversion device 100B in the third embodiment. Fig. 11 corresponds to Fig. 1 in the first embodiment. The electric power conversion device 100B loads the plurality of capacitors 40 which is narrow in terminal spacing such as ceramic capacitors and so forth. These capacitors 40 form in parallel relative to the first power module 201 and the second power module 202.

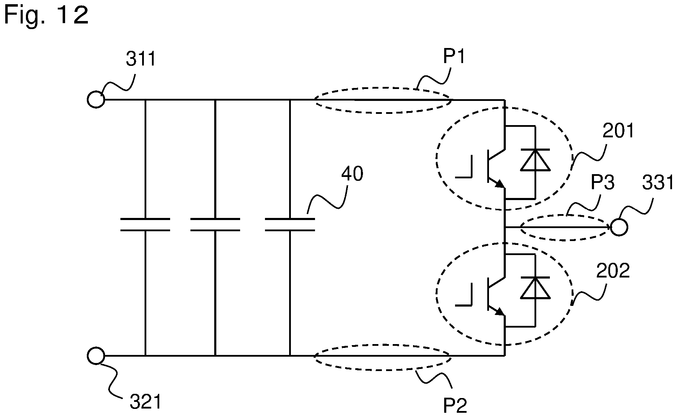

Fig. 12 is an electric circuit diagram of the electric power conversion device 100B. The electric power conversion device 100B is equipped with the plurality of capacitors 40 which is connected in parallel as shown in Fig. 12.

According to the above-described third embodiment, the following operational effect can be obtained in addition to the operational effects in the first embodiment.

(9) The plurality of capacitors 40 is arranged on the DC paths P1 and P2 of the electric power conversion device 100B at positions where they are not covered with the flow path forming body 25. Each of the plurality of capacitors 40 is electrically connected in parallel with the power module 20. Accordingly, the plurality of electric current paths can be secured, the magnetic flux cancellation effect between the cathode conductor layer 31 and the anode conductor layer 32 is strengthened and the inductance can be reduced.

In the above-described respective embodiments and modified example, the configuration of the functional block is merely one example. Several functional configurations which are shown as separate functional blocks may be integrally configured, and a configuration which is shown by one functional block diagram may be divided into two or more functions. In addition, such a configuration may be also made that other functional blocks possess some of functions that each functional block has.

Reference Signs List

| | |
|---|---|
| 100, 100A, 100B | electric power conversion device |
| 20 | power module |
| 201 | first power module |
| 202 | second power module |
| 23 | mold resin |
| 25 | flow path forming body |
| 30 | substrate |
| 31 | cathode conductor layer |
| 32 | anode conductor layer |
| 33 | AC output terminal conductor |
| 301 | direct-flow path hole |
| 302 | sub-flow path hole |
| 303 | resin-filled hole |
| 304 | DC side resin-filled hole |
| 305 | AC side resin-filled hole |
| 40 | capacitor |
| 50 | control circuit |
| 51 | control signal wiring |
| 52 | intra-flow path substrate wiring |

**Claims**

1. An electric power conversion device (100; 100B) comprising:

a power module (20) which converts DC electric power to AC electric power;
a substrate (30) that the power module (20) is arranged and a DC path which transmits the DC electric power to the power module (20) is included and which has a first surface (S1) and a second surface (S2) which confronts the first surface (S1) and has a plurality of main flow path holes (301) which is pierced therethrough from the first surface (S1) to the second surface (S2); and
a flow path forming body (25) which covers at least parts of the first surface (S1) and the second surface (S2) of the substrate (30) so as to cover the plurality of main flow path holes (301) and forms a flow path of a refrigerant which cools the power module (20), **characterized in that**
the plurality of main flow path holes (301) is arranged at a position where they cross the DC path,
the refrigerant migrates from the first surface (S1) to the second surface (S2), passing through the main flow path holes (301),
the power module (20) is cooled with the refrigerant which flows along the first surface (S1) and with the refrigerant which flows along the second surface (S2), and
the substrate (30) further has a plurality of sub-flow path holes (302) which is pierced therethrough from the first surface (S1) to the second surface (S2), crossing an AC path which transmits the AC electric power to the power module (20).

2. The electric power conversion device (100; 100B) according to claim 1, wherein
the substrate (30) is configured by laminating a cathode conductor layer (31) that the electric current which flows into the power module (20) flows and an anode conductor layer (32) that the electric current which flows out of the power module (20) flows.

3. The electric power conversion device (100; 100B) according to claim 1, wherein

a capacitor (40) is arranged on the DC path at a position where it is not covered with the flow path forming body (25), and
the capacitor (40) is electrically connected in parallel with the power module (20).

4. The electric power conversion device (100; 100B) according to claim 1, wherein
the power module (20) is configured by including a first power module (20) which configures an upper arm and a second power module (20) which configures a lower arm.

5. The electric power conversion device according to claim 1, wherein

the power module is sealed with a resin,
the flow path forming body covers an outer periphery of the resin,
the substrate further has a plurality of resin-filled holes which is filled with the resin and is pierced therethrough from the first surface to the second surface, and
the plurality of resin-filled holes is arranged at a position where they cross the DC path.

6. The electric power conversion device according to claim 5, wherein
a diameter of the resin-filled hole is smaller than a diameter of the main flow path hole.

7. The electric power conversion device (100; 100B) according to claim 1, wherein

a plurality of capacitors (40) is arranged at positions where they are not covered with the flow path forming body (25), and
each of the plurality of capacitors (40) is electrically connected in parallel with the power module (20).

**Patentansprüche**

1. Elektrische Leistungsumwandlungsvorrichtung (100; 100B), umfassend:

ein Leistungsmodul (20), das elektrische Gleichstromleistung in elektrische Wechselstromleistung umwandelt;
ein Substrat (30), auf dem das Leistungsmodul (20) angeordnet ist und in dem ein Gleichstromweg enthalten ist, der die elektrische Gleichstromleistung an das Leistungsmodul (20) überträgt, und das eine erste Oberfläche (S1) und eine zweite Oberfläche (S2) aufweist, die der ersten Oberfläche (S1) gegenüberliegt, und das eine Vielzahl von Hauptströmungsweglöchern (301) aufweist, die von der ersten Oberfläche (S1) zu der zweiten Oberfläche (S2) durchbohrt sind; und
einen Strömungswegausbildungskörper (25), der zumindest Teile der ersten Oberfläche (S1) und der zweiten Oberfläche (S2) des Substrats (30) abdeckt, um die Vielzahl von Hauptströmungsweglöchern (301) abzudecken, und der einen Strömungsweg eines Kältemittels ausbildet, das das Leistungsmodul (20) kühlt,
**dadurch gekennzeichnet, dass**
die Vielzahl von Hauptströmungsweglöchern (301) an einer Position angeordnet ist, an der sie den Gleichstromweg kreuzen,
das Kältemittel von der ersten Oberfläche (S1) zu der zweiten Oberfläche (S2) wandert und durch die Hauptströmungsweglöcher (301) hindurchgeht,
das Leistungsmodul (20) mit dem Kältemittel, das entlang der ersten Oberfläche (S1) strömt, und mit dem Kältemittel, das entlang der zweiten Oberfläche (S2) strömt, gekühlt wird, und
das Substrat (30) ferner eine Vielzahl von Nebenströmungsweglöchern (302) aufweist, die von der ersten Oberfläche (S1) zu der zweiten Oberfläche (S2) durchbohrt sind und einen Wechselstromweg kreuzen, der die elektrische Wechselstromleistung an das Leistungsmodul (20) überträgt.

2. Elektrische Leistungsumwandlungsvorrichtung (100; 100B) nach Anspruch 1, wobei
das Substrat (30) durch Laminieren einer Kathodenleiterschicht (31), durch die der elektrische Strom, der in das Leistungsmodul (20) fließt, fließt, und einer Anodenleiterschicht (32), durch die der elektrische Strom, der aus dem Leistungsmodul (20) fließt, fließt, konfiguriert ist.

3. Elektrische Leistungsumwandlungsvorrichtung (100; 100B) nach Anspruch 1, wobei

ein Kondensator (40) auf dem Gleichstromweg an einer Position angeordnet ist, an der er nicht mit dem Strömungswegbildungskörper (25) bedeckt ist, und
der Kondensator (40) elektrisch parallel mit dem Leistungsmodul (20) verbunden ist.

4. Elektrische Leistungsumwandlungsvorrichtung (100; 100B) nach Anspruch 1, wobei
das Leistungsmodul (20) durch Einschließen eines ersten Leistungsmoduls (20), das einen oberen Arm konfiguriert, und eines zweiten Leistungsmoduls (20), das einen unteren Arm konfiguriert, konfiguriert ist.

5. Elektrische Leistungsumwandlungsvorrichtung nach Anspruch 1, wobei

das Leistungsmodul mit einem Harz abgedichtet ist,
der Strömungswegausbildungskörper einen Außenumfang des Harzes abdeckt,
das Substrat ferner eine Vielzahl von harzgefüllten Löchern aufweist, die mit dem Harz gefüllt sind und von der ersten Oberfläche zu der zweiten Oberfläche durchbohrt sind, und
die Vielzahl von harzgefüllten Löchern an einer Position angeordnet ist, an der sie den Gleichstromweg kreuzen.

6. Elektrische Leistungsumwandlungsvorrichtung nach Anspruch 5, wobei
ein Durchmesser des harzgefüllten Lochs kleiner als ein Durchmesser des Hauptströmungsweglochs ist.

7. Elektrische Leistungsumwandlungsvorrichtung (100; 100B) nach Anspruch 1, wobei

eine Vielzahl von Kondensatoren (40) an Positionen angeordnet ist, an denen sie nicht mit dem Strömungswegausbildungskörper (25) bedeckt sind, und
jeder der Vielzahl von Kondensatoren (40) elektrisch parallel mit dem Leistungsmodul (20) verbunden ist.

**Revendications**

1. Dispositif de conversion d'énergie électrique (100 ; 100B) comprenant :

un module d'alimentation (20) qui convertit de l'énergie électrique CC en énergie électrique CA ;

un substrat (30) sur lequel le module d'alimentation (20) est agencé et un trajet CC qui transmet l'énergie électrique CC au module d'alimentation (20) est inclus et qui a une première surface (S1) et une seconde surface (S2) qui fait face à la première surface (S1) et a une pluralité de trous de trajet d'écoulement principaux (301) qui sont percés à travers celui-ci de la première surface (S1) à la seconde surface (S2) ; et

un corps de formation de trajet d'écoulement (25) qui recouvre au moins des parties de la première surface (S1) et de la seconde surface (S2) du substrat (30) de manière à recouvrir la pluralité de trous de trajet d'écoulement principaux (301) et forme un trajet d'écoulement d'un réfrigérant qui refroidit le module d'alimentation (20), **caractérisé en ce que**

la pluralité de trous de trajet d'écoulement principaux (301) est agencée à une position où ils croisent le trajet CC,

le réfrigérant migre de la première surface (S1) à la seconde surface (S2), passant à travers les trous de trajet d'écoulement principaux (301),

le module d'alimentation (20) est refroidi avec le réfrigérant qui s'écoule le long de la première surface (S1) et avec le réfrigérant qui s'écoule le long de la seconde surface (S2), et

le substrat (30) a en outre une pluralité de trous de trajet d'écoulement secondaires (302) qui sont percés à travers celui-ci de la première surface (S1) à la seconde surface (S2), croisant un trajet CA qui transmet l'énergie électrique CA au module d'alimentation (20).

2. Dispositif de conversion d'énergie électrique (100 ; 100B) selon la revendication 1, dans lequel le substrat (30) est configuré en stratifiant une couche conductrice de cathode (31) dans laquelle le courant électrique qui s'écoule dans le module d'alimentation (20) s'écoule et une couche conductrice d'anode (32) dans laquelle le courant électrique qui s'écoule hors du module d'alimentation (20) s'écoule.

3. Dispositif de conversion d'énergie électrique (100 ; 100B) selon la revendication 1, dans lequel

un condensateur (40) est agencé sur le trajet CC à une position où il n'est pas recouvert avec le corps de formation de trajet d'écoulement (25), et

le condensateur (40) est électriquement connecté en parallèle avec le module d'alimentation (20).

4. Dispositif de conversion d'énergie électrique (100 ; 100B) selon la revendication 1, dans lequel le module d'alimentation (20) est configuré en incluant un premier module d'alimentation (20) qui configure un bras supérieur et un second module d'alimentation (20) qui configure un bras inférieur.

5. Dispositif de conversion d'énergie électrique selon la revendication 1, dans lequel

le module d'alimentation est scellé avec une résine,

le corps de formation de trajet d'écoulement recouvre une périphérie externe de la résine,

le substrat a en outre une pluralité de trous remplis de résine qui sont remplis avec la résine et sont percés à travers celui-ci de la première surface à la seconde surface, et

la pluralité de trous remplis de résine est agencée à une position où ils croisent le trajet CC.

6. Dispositif de conversion d'énergie électrique selon la revendication 5, dans lequel un diamètre du trou rempli de résine est plus petit qu'un diamètre du trou de trajet d'écoulement principal.

7. Dispositif de conversion d'énergie électrique (100 ; 100B) selon la revendication **1,** dans lequel

une pluralité de condensateurs (40) est agencée à des positions où ils ne sont pas recouverts avec le corps de formation de trajet d'écoulement (25), et

chacun de la pluralité de condensateurs (40) est électriquement connecté en parallèle avec le module d'alimentation (20).

Fig. 1

EP 4 131 763 B1

Fig. 2

Fig. 3

Fig. 4

Fig. 5

Fig. 6

EP 4 131 763 B1

Fig. 7

Fig. 8

Fig. 9

EP 4 131 763 B1

Fig. 10

Fig. 11

EP 4 131 763 B1

Fig. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015043690 A
- US 2014198449 A1
- US 2012228757 A1
- WO 2013151606 A1
- US 2008224303 A1